(19) Europäisches Patentamt
European Patent Office
Office européen des brevets

(11) **EP 4 094 084 B1**

(12) **FASCICULE DE BREVET EUROPEEN**

(45) Date de publication et mention
de la délivrance du brevet:
**12.03.2025   Bulletin 2025/11**

(21) Numéro de dépôt: **21700750.9**

(22) Date de dépôt: **15.01.2021**

(51) Classification Internationale des Brevets (IPC):
**G01R 31/367** *(2019.01)*      **G01R 31/392** *(2019.01)*

(52) Classification Coopérative des Brevets (CPC):
**G01R 31/392; G01R 31/367**

(86) Numéro de dépôt international:
**PCT/EP2021/050820**

(87) Numéro de publication internationale:
**WO 2021/148324 (29.07.2021 Gazette 2021/30)**

(54) **PROCEDE DE DIAGNOSTIC RAPIDE ET HORS LIGNE D'ACCUMULATEURS ET DISPOSITIFS ASSOCIES**

VERFAHREN ZUR SCHNELLEN OFFLINE-DIAGNOSE VON AKKUMULATOREN UND ZUGEHÖRIGE VORRICHTUNGEN

METHOD FOR RAPID OFFLINE DIAGNOSIS OF ACCUMULATORS, AND RELATED DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **21.01.2020   FR 2000581**

(43) Date de publication de la demande:
**30.11.2022   Bulletin 2022/48**

(73) Titulaire: **IFP Energies nouvelles**
**92500 Rueil-Malmaison (FR)**

(72) Inventeurs:
• **BECK, David**
**92852 RUEIL-MALMAISON CEDEX (FR)**
• **MINGANT, Remy**
**92852 RUEIL-MALMAISON CEDEX (FR)**
• **BERNARD, Julien**
**92852 RUEIL-MALMAISON CEDEX (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**US-A1- 2011 060 538     US-A1- 2012 007 556**
**US-B2- 10 302 703**

## Description

### Domaine technique

La présente invention concerne le domaine du diagnostic hors ligne de batteries.

L'évolution du contexte environnemental, économique et réglementaire a favorisé l'émergence des véhicules électriques et hybrides et par voie de conséquence, des batteries. En effet, depuis ces dernières années, le développement de la mobilité électrique à grande échelle est en train de provoquer une augmentation notable de production de batteries. Ainsi, nous commençons à assister à l'arrivée massive de batteries dans les centres de SAV (acronyme pour « Service Après-Vente ») mais aussi à l'accumulation de batteries de traction usagées qui ne sont plus en mesure de faire fonctionner un véhicule, en attente d'un recyclage. La plupart des batteries restent néanmoins capables de fournir assez d'énergie pour être intégrées dans d'autres applications. Une seconde vie permettrait de revaloriser ces batteries usagées qui pourraient tout à fait accomplir ce que font les batteries neuves dans des applications, comme le stockage stationnaire, moins gourmandes en puissance et où le volume et la masse ne sont pas des critères critiques.

La détermination de l'état de santé et en particulier de la capacité résiduelle de batteries est difficile en raison de la complexité des mécanismes de dégradation au cours du temps, dont la cinétique répond à des lois non linéaires en ce qui concerne notamment les batteries Li-Ion (notées aussi lithium-ion), de leur grande variabilité, à savoir différentes chimies de batteries lithium-ion, et de la diversité de leurs usages, même en contrôlant les conditions de fonctionnement. Cependant, elle est d'une importance cruciale étant donné son utilité générale. La détermination de l'état de santé des batteries peut se faire à différents instants de la vie de la batterie :

- En ligne *in-situ,* c'est-à-dire par un BMS (acronyme anglais pour « Battery Management System » pouvant être traduit par système de gestion de batterie) au cours du fonctionnement de la batterie. Dans ce cas, le BMS bénéficie de l'historique de la vie de la batterie et peut mettre à jour l'état de santé en continu à partir d'un état neuf.

- Hors ligne, *ex-situ,* c'est-à-dire lorsque la batterie est retirée de son application, par exemple pour une phase de maintenance, en fin de première vie ou à destination d'un marché de l'occasion. Généralement dans ce cas, l'opérateur ne bénéficie de peu voire d'aucune information concernant la vie de la batterie, l'historique de son fonctionnement, ni de son état de charge à l'instant t. La seule technique fiable à ce jour consiste à charger puis décharger complètement la batterie pour déterminer sa capacité résiduelle. Cette mesure prend plusieurs heures avec des équipements couteux, et n'est pas compatible avec les contraintes de temps induites par les volumes de batteries à traiter dans le futur. Des techniques de mesures courtes basées sur une mesure de résistance ou d'impédance existent mais elles ne peuvent donner la valeur de la capacité résiduelle de la batterie que dans le cas de l'établissement au préalable d'une relation du type mathématique, en mettant en œuvre un algorithme, entre des paramètres de résistance ou d'impédance et la capacité. Cette relation est généralement peu fiable et non systématique, et nécessite en amont la réalisation de campagnes de vieillissement pour la déterminer, campagnes longues et couteuses à renouveler pour chaque nouvelle référence de batterie.

La demande de brevet US 2011/0060538 A1 décrit une méthode d'estimation de l'état de santé d'une batterie.

La demande de brevet US 10302703 B2 décrit une méthode de surveillance de sécurité d'une batterie.

La présente invention concerne notamment le domaine des batteries, en particulier de type Li-ion non embarquées provenant d'un véhicule électrique, à assistance électrique, véhicule électrique hybride rechargeable ou tout autre dispositif utilisant une batterie, la batterie étant composée d'une cellule ou d'une pluralité de cellules. Les batteries dites de traction sont des batteries qui servent à la propulsion de véhicules, comme cela est le cas des véhicules électriques VE (acronyme anglais pour « Electric Vehicle ») tractés exclusivement par un moteur électrique alimenté par une batterie, mais également le cas des véhicules hybrides comprenant un moteur électrique alimenté par une batterie associé à un autre système de propulsion, tel qu'un moteur thermique, pour propulser le véhicule. Parmi les véhicules hybrides électriques HEV (acronyme anglais pour « Hybrid Electric Vehicle »), on distingue les véhicules hybrides rechargeables PHEV (acronyme anglais pour « Plug-in Hybrid Electric Vehicle »), pour lesquels la batterie de traction peut être chargée par branchement à une source d'énergie externe, classiquement appelée borne de recharge, des véhicules hybrides électriques non rechargeables, c'est-à-dire qui ne sont pas équipés pour une telle recharge régulière de la batterie sur un réseau électrique extérieur. Dans ce domaine de la mobilité on peut mentionner également les VAE (acronyme pour « Véhicules à Assistance Électrique »), trottinettes électriques, scooters, bus, poids-lourds, ou tout autre dispositif permettant la mobilité.

Plus précisément, la présente invention concerne le diagnostic des batteries de véhicules électriques pour tous types de mobilités de la micro-mobilité aux véhicules industriels, et en particulier le domaine du SAV de batteries, du reconditionnement de batteries pour la seconde vie, et de l'évaluation d'une valeur marchande d'une batterie d'occasion (Argus, marché de l'occasion). Peuvent également entrer dans le domaine d'application de l'invention, tous les autres domaines utilisant des batteries, par exemple les outils électriques portatifs ou tout autre dispositif utilisant une batterie, pour lesquels une réutilisation est envisageable.

Une batterie électrique est un organe complexe constitué d'accumulateurs, également appelés éléments ou cellules, connectés en série et/ou parallèle, généralement équilibrés entre eux par des composants électroniques afin de maintenir un état de charge homogène pour l'ensemble de la batterie. Une batterie électrique permet de transformer réversiblement de l'énergie électrochimique en énergie électrique. Les batteries de type lithium-ion (Li-ion) constituent en particulier une technologie de choix pour l'alimentation des véhicules électriques, hybrides et hybrides rechargeables.

Avec le vieillissement, les batteries présentent une dégradation de leurs performances, qui se manifeste par une diminution de leur capacité et par l'augmentation de leur résistance interne ou de leur impédance électrique. La perte de capacité se traduit par une diminution de l'autonomie tandis que l'augmentation de résistance interne ou d'impédance se traduit par une diminution de la puissance pouvant être délivrée ou absorbée par la batterie. Au sein d'un véhicule électrique ou hybride rechargeable, les batteries vieillissent au cours de leur utilisation répétitive en conduite, selon un mode nommé "cyclage électrique", mais aussi lorsque le véhicule est au repos, il s'agit alors d'un vieillissement en mode "calendaire" (les statistiques montrent que les véhicules légers passent couramment plus de 90 % de leur vie dans un parking). Dans le cas du vieillissement calendaire, en l'absence de courant de charge-décharge, les seuls paramètres qui influent sur l'état de santé de la batterie sont la température et l'état de charge. Pour une application donnée, la fin de vie des batteries est anticipée par le constructeur de véhicule, qui définit une limite pour laquelle la baisse de performance et le risque de défaillance accru sont considérés comme intolérables. Généralement, une perte de 20 % de la capacité nominale et/ou une augmentation de 100 % de la résistance interne fixent la fin de vie de la batterie de traction, ou son passage à une deuxième vie dans des applications moins exigeantes en puissance.

Causes et effets de la défaillance des batteries :

Les batteries Li-ion offrent l'un des meilleurs rapports de densité énergétique (Wh/kg). Elles ne présentent pas d'effet mémoire et ont une faible autodécharge lorsqu'elles ne sont pas utilisées. Ces aspects ont favorisé l'adoption du lithium comme source d'alimentation principale pour la plupart des appareils électroniques et, par conséquent, elles ont également contribué à stimuler le développement de véhicules hybrides et de véhicules électriques. Pour avoir un impact sur le marché actuel des véhicules, composé encore en grande partie de véhicules à combustion interne, ces véhicules alimentés par batterie doivent satisfaire aux exigences de performance existantes en termes de puissance mais surtout d'autonomie. Les batteries doivent durer assez longtemps pour satisfaire les consommateurs. En raison de ces exigences, des recherches rigoureuses ont été effectuées pour déterminer et quantifier les processus par lesquels la batterie se dégradera. Mieux comprendre ces processus de dégradation permettra de limiter le vieillissement et augmentera la durée de vie des batteries et, par conséquent, renforcera l'acceptabilité des consommateurs.

Mécanismes de dégradation de la batterie :

Au cours de sa vie, la batterie subit de nombreux mécanismes de vieillissement influencés par la température, l'état de charge SOC (acronyme anglais pour « State of Charge »), la profondeur de décharge DOD (acronyme anglais pour « Depth Of Decharge »), le courant C de charge/décharge et le temps. De plus, ces mécanismes sont liés entre eux.

Par ailleurs, la perte de capacité et la diminution de puissance peuvent ne provenir pas d'une seule cause, mais d'un certain nombre de réactions diverses et de leurs interactions les unes avec les autres. De plus, la majorité de ces processus ne peuvent pas être étudiés indépendamment et se produisent à des échelles de temps similaires, ce qui complique l'étude des mécanismes du vieillissement, et ultérieurement complique l'estimation de l'état de santé de la batterie.

Types de défaillance :

Ces mécanismes de dégradation vont éventuellement provoquer la panne de la batterie. Cependant, en fonction des mécanismes déclenchés à cause de l'utilisation de la batterie, la défaillance peut être plus ou moins soudaine.

La défaillance est définie comme l'incapacité d'un composant ou d'un système à accomplir sa fonction.

Les modes de défaillance de composants électriques ou électroniques se classent généralement en deux catégories :

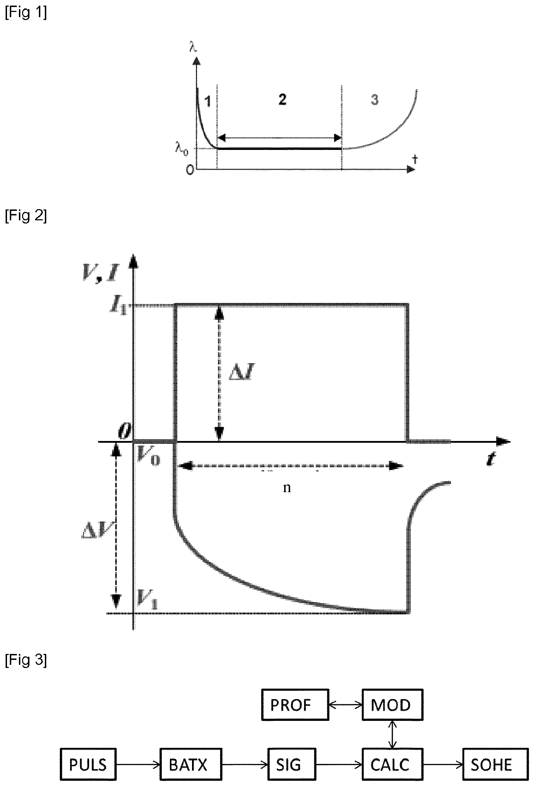

1. Défaillances catalectiques, qui peuvent être défaillances soudaines et complètes. La figure 1 illustre la variation du taux de défaillance $\lambda(t)$ en fonction du temps, courbe en baignoire modélisable par la loi de Weibull. Sur cette figure 1 on retrouve une Zone 1, qui représente la période de défaillances précoces, une Zone 2 qui représente une période de durée de vie utile et finalement une Zone 3, qui est une période d'usure. Par exemple, le court-circuit interne d'une cellule ou d'un bloc peut s'inscrire dans la catégorie « défaillance catalectique ». Ce type de défaillance se produit principalement au début de la vie des composants, c'est-à-dire dans la Zone 1 de la figure 1. Nous pouvons donc supposer que dans un pack comportant une cellule défaillante, autrement dit hors service, les autres cellules de ce pack sont encore en bonne santé et n'ont subi qu'une dégradation continue sur une période écourtée. La capacité de ces batteries serait donc faiblement réduite (<20 % de perte de capacité). Les batteries dites « de seconde vie » sont généralement mises hors service lorsque la capacité perdue est supérieure à 20 % de la capacité initiale. Du fait des défaillances catalectiques de cellules, certains packs peuvent contenir des cellules quasi neuves.

2. Défaillances par dégradation qui peuvent être progressives et partielles, correspondant au vieillissement normal en usage : dans les défaillances par dégradation on peut distinguer le vieillissement calendaire et le vieillissement en cyclage. Le vieillissement calendaire comprend tous les processus de vieillissement qui conduisent à la dégradation d'une cellule de batterie indépendamment du cycle charge-décharge. C'est un facteur important dans de nombreuses applications des batteries lithium-ion où les périodes de fonctionnement sont sensiblement plus courtes que les périodes de repos, comme dans les VE ou VAE. De plus, la dégradation due au vieillissement calendaire peut aussi être prédominante dans les études sur le vieillissement cyclique, en particulier lorsque les profondeurs de cycle et les courants sont faibles.

Vieillissement calendaire :

La batterie Lithium-ion se dégrade même si elle n'est pas sollicitée. Le vieillissement calendaire correspond donc à la perte irréversible de capacité pendant sa période de stockage. Sa durée de vie est la durée en années pendant laquelle la capacité de la batterie passe de 100 % à 80 % (80 % est une valeur communément admise en tant que limite pour SOHE). Le vieillissement calendaire est très dépendant du SOC mais surtout de la température, les températures élevées étant les plus nuisibles. En fonction des conditions de stockage des cellules, il est possible d'accélérer ou de ralentir la dégradation

[Math.1]

$$SOH = f(SOC, T)$$

Il est communément connu que les niveaux élevés de SOC ont un impact négatif sur la dégradation de la capacité de la batterie par rapport aux SOC bas, de plus, la dégradation d'une batterie est plus importante à haute température.

Vieillissement en cyclage :

Le cyclage d'une batterie entraîne un vieillissement supplémentaire au vieillissement calendaire dû à la présence de courant dans la batterie, soit en charge soit en décharge.

Contrairement au vieillissement calendaire, la perte de capacité en cyclage est modélisée comme une interaction entre le courant I, l'état de charge SOC, la température T, et le taux de charge $C_r$. Cependant, d'autres facteurs joueraient également un rôle, comme la profondeur de décharge DOD et le débit énergétique Ah, $C_Q$.

[Math.2]

$$SOH = f(I, C_r, T, SOC, DOD, C_Q)$$

Les températures élevées sont généralement dommageables aux batteries lithium-ion car elles accélèrent les cinétiques des réactions de dégradation à la fois en calendaire et en cyclage. Les températures basses peuvent également être fortement dommageables lors des phases de charge à travers la formation de dendrites et de lithium métallique (*lithium plating.* Cependant, comme évoqué précédemment, il est très difficile de mesurer les contributions individuelles des vieillissements en cyclage et calendaire, étant donné que le les mécanismes ayant lieu lors du vieillissement calendaire se produisent également pendant les périodes de cyclage de la batterie.

Etat de santé (SOH):

L'état de santé ou SOH (acronyme anglais pour « State of Health ») est une mesure qui reflète l'état général d'une batterie. Le SOH diminue tout au long de la vie de la batterie à cause des mécanismes de vieillissement cités ci-dessus. Cette valeur sert de point de repère pour savoir à quel moment il est nécessaire de remplacer la batterie. Le SOH s'exprime en pourcentage et peut être calculé à partir de deux paramètres différents, la capacité ou la résistance. On distingue,

le SOHE (Energie) :

[Math.3]

$$SOH_E = \frac{Q_{act}}{Q_{nom}}$$

le SOHP (Puissance) :

[Math.4]

$$SOH_P = \frac{R_{nom}}{R_{act}}$$

Où:

$Q_{act}$ est la capacité actuelle mesurée (Ah),
$Q_{nom}$ est la capacité de la cellule neuve (Ah),
$R_{nom}$ est la résistance à l'état neuf ($\Omega$) et
$R_{act}$ est la résistance actuelle mesurée ($\Omega$).

La fin de vie d'une batterie est présumée atteinte lorsque le $SOH_E$ atteint 80 % ou lorsque le $SOH_P$ double.

Dans cette invention, le $SOH_E$ va servir de référence pour le SOH. En effet, la capacité de la batterie est le critère dominant lors des études sur la seconde vie.

L'estimation du SOH est une tâche compliquée car la dégradation des batteries se produit dans chaque cellule d'un module de batterie au fil du temps, et l'estimation du SOH lors d'une décharge permet de seulement estimer le SOH de la cellule la plus faible. Il est donc important de développer une méthode performante afin de pouvoir estimer le SOH le plus précisément possible. Le vieillissement des cellules peut être évalué à l'aide de modèles de vieillissement des batteries, mais ces modèles ne peuvent pas caractériser toutes les influences sur le système, comme par exemple les dommages causés par les collisions de véhicules ou les courts-circuits de batterie.

Il existe plusieurs méthodes pour déterminer l'état de santé des batteries $SOH_E$ d'une cellule :
Mesure directe du SOHR : la mesure directe classique du SOHR (acronyme anglais pour « State of Health » Réel) avec laquelle il est possible de déterminer directement le $SOH_E$. La mesure directe peut s'effectuer avec le test de capacité en décharge. Cette méthode temporelle est la plus classique.

Estimation du SOHE :

Les méthodes de diagnostic de l'indice de santé SOHE se basent sur des mesures de $SOH_P$ et d'algorithmes de traitement de données afin d'estimer le $SOH_E$. On peut mentionner des méthodes basées sur l'application d'au moins un pulse (signal temporel) de courant ou de tension et le EIS (acronyme anglais pour « Electrochemical Impedance Spectroscopy » pouvant être traduit par Spectroscopie d'impédance électrochimique).

Contrairement au test de capacité en décharge classique, la méthode de l'impulsion de courant ou de tension donne directement le SOHP. En effet, selon le courant $I_1$ appliqué, la tension $V_0$ chute à $V_1$. Ce $\varDelta V$ permet de déterminer le $SOH_P$ grâce à la loi d'Ohm :

[Math.5]

$$R_i = \frac{\varDelta V}{\varDelta I} = \frac{V_1 - V_0}{I_1}$$

L'un des inconvénients traditionnels de la technique d'impulsion à CC est représenté par le fait que des impulsions de courant de charge et de décharge élevées ne peuvent pas être appliquées à des niveaux de SOC élevés et faibles, respectivement, pour des températures basses, puisque les valeurs de tension maximale et minimale des batteries seront atteintes. L'inconvénient principal est que le lien avec le $SOH_E$ soit non trivial à cause de la relation ambigüe entre la capacité et la résistance.

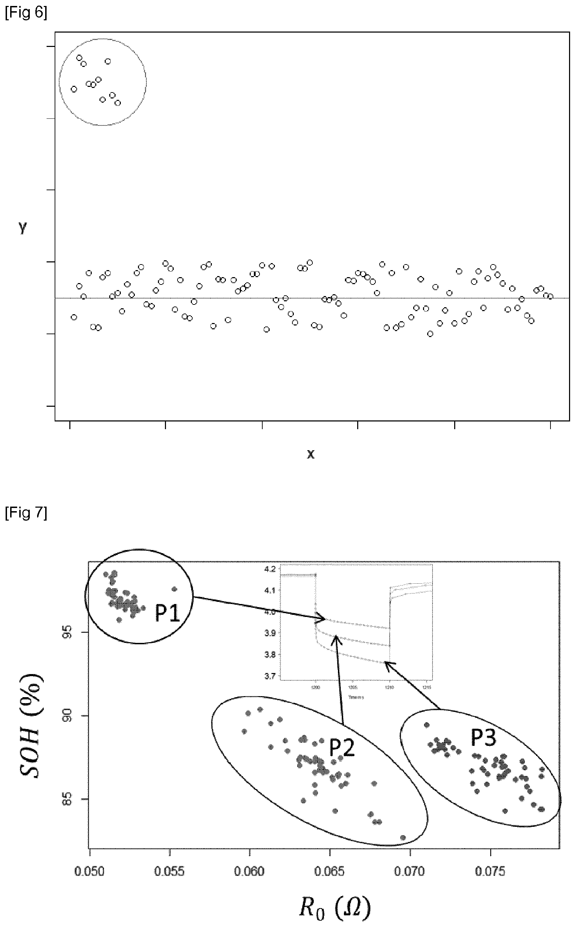

Un exemple de relation non triviale de cette relation entre la capacité et la résistance est illustré sur la figure 7. La figure 7, montre le SOHR de chaque cellule de 3 packs de batteries testés lors d'une campagne de tests en fonction de leur résistance R0 à 50 % d'état de charge. Sur cette figure 7 on distingue les 3 packs étudiés (P1, P2 et P3) et on constate qu'il n'existe pas de relation linéaire directe en ces deux paramètres, ce qui rend impossible la détermination du SOH à partir d'une simple mesure de résistance. Ces résultats démontrent la complexité des mécanismes de dégradation. Le dispositif et le procédé de l'invention mettent en œuvre une nouvelle méthode rapide qui ne se base pas sur cette relation circonstancielle.

**Technique antérieure**

La spectroscopie d'impédance électrochimique EIS est une technique de caractérisation qui permet de déterminer les paramètres caractéristiques (résistance, capacité...) des étapes du processus réactionnel d'un système électrochimique par l'application d'un signal sinusoïdal (en courant ou en tension) d'excitation en courant alternatif. Ce signal est de très faible amplitude (par exemple quelques millivolts) autour d'un point de fonctionnement supposé stationnaire. Il est ainsi possible d'observer la réponse électrique en tension qui correspond à l'état du système au moment de la perturbation. Un spectre d'impédance est obtenu en faisant varier la fréquence sur une plage définie (de 10 kHz à 1 MHz par exemple).

Cette caractérisation permet de déterminer l'impédance électrique (grandeur complexe) puis de modéliser un système électrochimique par analogie avec des composants électriques de type inductances, résistances, condensateurs, etc.

En haute fréquence, l'intersection avec l'axe des abscisses permet de déterminer la résistance ohmique, la boucle capacitive est associée à la résistance de transfert de charge en parallèle avec la capacité de double couche, et la partie linéaire du diagramme correspond à l'impédance de Warburg (diffusion des espèces électroactives).

La résistance du système peut ensuite être calculée en analysant le spectre d'impédance. A nouveau, cette méthode, cette fois-ci, fréquentielle, permet d'obtenir le $SOH_P$ et non le $SOH_E$.

De plus, ce test nécessite une cartographie de référence qui relie les évolutions des spectres d'impédances dans le temps avec les états de charge (SOC) et les états de santé (SOH).

Dans le principe de diagnostic in situ de batteries par technique EIS tel que décrit dans la demande de brevet FR3044424, le SOC, le SOH et l'impédance électrochimique sont déterminés pour différents états internes de batteries. Le modèle de prédiction dans ce principe est ensuite défini selon ces trois paramètres puis calibré. Lorsque l'impédance de la batterie étudiée est mesurée, son SOH ou SOC est estimé au moyen du modèle de prédiction basé sur la cartographie établie en amont.

De plus en plus, les méthodes « orientées data » s'introduisent sur le marché. Elles peuvent être définies comme les techniques nécessitant une large base de données de cellules vieillies, dont l'efficacité dépend fortement de la qualité et de la taille de l'ensemble de données. Leur forte capacité d'apprentissage fait d'eux des outils de prédiction puissants et performants. Un grand nombre de ces méthodes se sert des réseaux de neurones ANN (acronyme anglais pour « Artificial Neural Network » pouvant être traduit par réseau de neurones artificiel) et de la résistance interne de la batterie pour estimer le SOH. Cette dernière exprime la cinétique de la batterie par rapport à la capacité disponible. Elle est calculée pendant les tests de pulses à différents courants, et utilisée comme entrée du modèle ANN. L'inconvénient de ces méthodes repose sur le fait que les réseaux de neurones ont besoin d'une grande phase d'apprentissage alimenté par une base de données importante. Par conséquent, ces méthodes sont plutôt utilisées « online », intégrées au BMS qui s'autoalimente au fil du temps.

Le document US2016245876A dévoile un procédé et un dispositif pour évaluer le SOHE (acronyme anglais pour « State of Health » Energie pouvant être traduit par état de santé énergie) d'une batterie Li-Ion en utilisant un modèle basé sur une relation linéaire entre la perte de capacité et une variable mathématique calculée à partir d'un signal électrique mesuré, à savoir la tension de la phase de charge, sans faire allusion aux charges partielles. Il s'avère toutefois que le modèle basé sur une relation linéaire n'est pas satisfaisant pour décrire fidèlement le SOHE.

Le document US2019113577A dévoile une méthode d'estimation de la perte de capacité et de la durée de vie restante avec un algorithme de Machine Learning (pouvant être traduit par apprentissage automatique). La méthode met en œuvre les mesures des propriétés de la cellule : tension, courant, température et résistance interne afin de tracer la capacité en fonction de la tension Q(V) et retrouver ΔQ(V). Cette méthode utilise les données sur les décharges générées par des batteries commerciales LFP/graphite dans des conditions de charge rapide en début de vie (cellules neuves) qui n'ont pas encore montré de dégradation de la capacité. La méthode utilise un algorithme de Machine Learning pour prédire la durée de vie restante de la batterie mais sans pouvoir déterminer le SOHE.

La méthode et le dispositif décrits dans le document CN109932663A permettent l'évaluation de l'état de santé d'une batterie en temps réel, en mesurant une capacité de décharge et la résistance interne d'une batterie embarquée dans un véhicule qui roule. Les données sont placées dans un algorithme de Machine Learning pour estimer le SOHE. Cependant la méthode décrite ici est lente car nécessite la mesure de la capacité de décharge.

Le document CN109061508A dévoile une méthode d'estimation de l'état de santé SOHP (acronyme anglais pour « State of Health » Power pouvant être traduit par état de santé puissance) d'une batterie au Li-Ion pour véhicule électrique. Le procédé d'estimation comprend les étapes suivantes :

1) la construction d'un modèle circuit électrique équivalent du second ordre d'une batterie

2) l'identification d'un paramètre du modèle équivalent du second ordre, dans lequel le paramètre comprend une résistance interne ohmique R0 et un paramètre de liaison RC du second ordre ;

3) le calcul de la résistance interne ohmique R0 ;

4) le calcul de la valeur SOHP de la batterie.

Cependant cette méthode ne permet pas l'estimation de l'SOHE.

Le document CN103091642A concerne le domaine technique des méthodes de détermination des paramètres d'une batterie au lithium, en particulier la méthode d'estimation rapide de sa capacité en réalisant un test de résistance interne via une méthode de pulse de courant. Cette méthode prend en compte diverses résistances internes mesurées par l'application de courants sur un échantillon de batteries d'entraînement et établit un modèle de réseau neuronal de résistance-capacité interne basé sur les valeurs de capacité en sortie. Cependant cette méthode ne permet pas l'estimation du SOHE.

Une autre méthode est dite de double impulsion « double pulse », ou bien test de charge à double impulsion « Two-Pulse Load Test ». Dans ce dernier, la première impulsion stabilise la batterie par rapport à son historique et la deuxième impulsion établit les paramètres. On note que l'historique de la batterie avant l'application de la première impulsion a un effet significatif et variable sur la chute de tension $\Delta V$ pendant l'impulsion. Au fur et à mesure que la batterie vieillit, $\Delta V$ augmente. Avec moins de capacité disponible et une résistance interne plus importante, le courant de charge a un effet plus important sur la batterie, et donc, le $\Delta V$ augmente, cf. Coleman M., Hurley W.G., Lee C.K. An Improved Battery Characterization Method Using a Two-Pulse Load Test, IEEE Transactions on Energy Conversion, 2008, 23, 2, 708-713. DOI: 10.1109/TEC.2007.914329.

De plus, les méthodes dévoilées dans les documents de cet art antérieur ne semblent pas prendre en compte les aspects :

Détection de données atypiques : identification des cellules présentant des réponses électriques s'éloignant de celles présentes dans la base de données du modèle.

Adaptation du procédé et du dispositif à plusieurs échelles d'accumulateur : cellule - module avec un groupe de cellules - ensemble de modules formant le pack de batterie et batterie complète.

Les centres de SAV de véhicules électriques légers utilisant des batteries mais aussi les centres ou sociétés se lançant dans le reconditionnement et la réutilisation de batteries dans une seconde vie, sont demandeurs de nouvelles solutions de diagnostic plus rapides et plus précises.

**Résumé de l'invention**

Cette invention propose un dispositif et un procédé de diagnostic hors ligne pour déterminer la capacité résiduelle du SOHE d'une batterie usagée en un temps très court de l'ordre de quelques secondes. Pour cela l'invention met en œuvre des profils type de cellules, qui sont appliqués à des mesures de tension et de température réalisées pour la cellule considérée.

Selon l'invention, le dispositif permet d'effectuer le diagnostic d'une batterie, notamment de type Li-ion, non embarquée provenant d'un véhicule électrique, à assistance électrique, véhicule électrique hybride rechargeable ou tout autre dispositif utilisant une batterie, la batterie étant composée d'une cellule ou d'une pluralité de cellules, ledit dispositif comprenant :

- des moyens configurés pour appliquer à au moins une cellule de ladite batterie un signal électrique de courant I et/ou de tension U
- des moyens de mesure de la tension U et/ou de courant I et de la température T de ladite au moins une cellule de la batterie
- un module d'analyse, un modèle de prédiction construit à partir d'une une base de données contenant des profils type de cellules,
- le module d'analyse est configuré pour déterminer un indicateur de l'état de santé énergie d'au moins une cellule de ladite batterie en utilisant les mesures de tension U et/ou courant I et de température T provenant des moyens de mesure ainsi que le modèle de prédiction.

Selon un mode de réalisation de l'invention, le signal électrique de courant I et/ou de tension U est du type impulsionnel.

Selon un mode de réalisation de l'invention, le dispositif comprend une interface de communication avec un utilisateur, ladite interface est configurée pour afficher le SOHE.

Selon un mode de réalisation de l'invention, le module d'analyse est configuré pour détecter des données atypiques ayant un profil différent des profils type de cellules contenus dans la base de données.

Selon un mode de réalisation de l'invention, le dispositif comprend des moyens pour effectuer un test de charge et décharge d'une cellule pour déterminer un indicateur réel de l'état de santé d'au moins une cellule de de ladite batterie.

Selon un mode de réalisation de l'invention, le module d'analyse est configuré pour transmettre un nouveau profil type dans la base de données.

Selon un mode de réalisation de l'invention, le module d'analyse est du type apprentissage automatique.

Selon un mode de réalisation de l'invention, le module d'analyse met en œuvre un processus auto-apprenant.

Selon un mode de réalisation de l'invention, le module d'analyse est configuré pour analyser directement une batterie comprenant une pluralité de cellules connectées en série, en parallèle ou une combinaison de groupes de cellules connectés en série et en parallèle.

Selon un mode de réalisation de l'invention, le module d'analyse et/ou la base de données sont configurés pour être déportés à distance, préférablement dans un nuage informatique.

L'invention concerne également un procédé de diagnostic d'une batterie, notamment de type Li-ion, non embarquée provenant d'un véhicule électrique, à assistance électrique, véhicule électrique hybride rechargeable ou tout autre dispositif utilisant une batterie, la batterie étant composée d'une cellule ou d'une pluralité de cellules, ledit procédé comprenant :

- une étape d'application à ladite au moins une cellule de la batterie un signal électrique de courant I et/ou de tension U
- une étape de mesure de la tension U et/ou de courant I et de la température T de ladite au moins une cellule de la batterie
- une étape délivrant le diagnostic d'au moins une cellule de ladite batterie, utilisant un module d'analyse des mesures de tension U et de température T,
- une étape de comparaison des mesures de tension U et/ou de courant I et de température T avec des profils type de cellules contenus dans une base de données afin de déterminer un indicateur de l'état de santé SOHE de ladite au moins une cellule de la batterie.

### Liste des figures

D'autres caractéristiques et avantages de l'invention, apparaîtront à la lecture de la description ci-après d'exemples non limitatifs de réalisation, en se référant aux figures annexées et décrites ci-après.

La figure 1 illustre le taux de défaillance de batteries λ en fonction du temps t.

La figure 2 illustre la variation de la tension et du courant théoriques en utilisant la méthode de l'impulsion de courant ou de tension.

La figure 3 illustre une mise en œuvre de l'invention.

La figure 4 illustre une mise en œuvre d'un mode de réalisation de l'invention.

La figure 5 illustre la relation de régression linéaire « Random Forest » entre les valeurs estimées SOHE et réelles SOHR de la capacité des cellules.

La figure 6 illustre un exemple de situation de données atypiques.

La figure 7 illustre la non trivialité entre SOH et la résistance R0 à 50 % SOC

Description détaillée de l'invention

L'objectif de la présente invention est de fournir un procédé et un dispositif d'évaluation de l'état de santé de batteries facile, pratique et efficace pour effectuer un test rapidement et avec précision.

Une batterie au sens de l'invention est un système de stockage réversible d'énergie électrique, ou accumulateur, sous forme électrochimique. La présente invention concerne tous types de technologie de batterie, notamment les batteries Lithium-ion, batteries au plomb, batteries NiMH, batteries NiCd, batteries Lithium-polymère, etc. Le dispositif permet d'effectuer le diagnostic d'au moins une cellule d'une batterie, notamment de type Li-ion non embarquée provenant d'un véhicule électrique, à assistance électrique, véhicule électrique hybride rechargeable ou tout autre dispositif utilisant une batterie.

Un pack batterie se compose d'un certain nombre de cellules. Ce nombre peut être un, et dans ce cas la batterie est composée d'une seule cellule. Cependant dans la majorité des cas une batterie comprend plusieurs groupes, modules ou blocs de cellules connectés en série, en parallèle ou une combinaison des deux. Chaque cellule est un assemblage d'une anode, d'un séparateur poreux et d'une cathode, l'ensemble baignant dans un électrolyte.

Le dispositif et le procédé de notre invention, illustré schématiquement sur la figure 3, est configuré pour effectuer le diagnostic d'au moins une cellule d'une batterie BATX, notamment de type Li-ion non embarquée provenant d'un véhicule électrique, à assistance électrique, véhicule électrique hybride rechargeable ou tout autre dispositif utilisant une batterie. La batterie BATX peut être composée d'une cellule ou d'une pluralité de cellules. Le dispositif et le procédé comprend en premier des moyens PULS configurés pour appliquer à au moins une cellule de ladite batterie un signal électrique de courant I. Ces moyens peuvent comprendre une source de courant électrique, un module de contrôle pour la mise en forme du signal et tout autre dispositif ou unité logique pour appliquer ledit signal.

Le dispositif et le procédé comprend également des moyens de mesure SIG de la tension U et de la température T de ladite au moins une cellule de la batterie. Ceci permet d'effectuer une mesure rapide de points caractéristiques en tension de la batterie.

Les moyens PULS peuvent alternativement être configurés pour appliquer à au moins une cellule de ladite batterie un signal électrique de tension U. Suivant cette alternative, les moyens de mesure SIG mesurent le courant I et de la température T de ladite au moins une cellule de la batterie. Ceci permet d'effectuer une mesure rapide de points caractéristiques en courant de la batterie. Une troisième alternative consiste à combiner les deux alternatives précédentes, afin d'appliquer et de mesurer une puissance qui correspond à U multiplié par I. Dans la suite de la description, la première alternative (impulsion de courant et mesure du signal de tension) est principalement décrite pour des raisons de simplification. La mise en œuvre des autres alternatives se déduit de cette première alternative.

Le dispositif et le procédé comprend également un module d'analyse CALC, un modèle de prédiction MOD et une base de données PROF contenant des profils type de cellules. Les données de la base de données de cellules de batteries PROF comprennent au moins des valeurs de tensions, courant et de température mesurées dans des conditions contrôlées, préférablement en utilisant les mêmes moyens PULS et SIG que pour la cellule BATX et des états de santé SOH de ces cellules des batteries utilisées pour établir la base de données. Le modèle de prédiction MOD est construit à partir de la base de données de cellules de batteries PROF.

Le module d'analyse CALC de ce dispositif et du procédé est configuré pour déterminer un indicateur de l'état de santé énergie SOHE d'au moins une cellule de de ladite batterie BATX en utilisant les points caractéristiques en tension de la batterie, à savoir les mesures de tension U et de température T provenant des moyens de mesure SIG ainsi que le modèle de prédiction MOD. Suivant la première alternative de mise en œuvre de l'invention, la mesure de la tension U est utilisée pour évaluer le $\Delta V$.

Dans un mode de réalisation de l'invention, le signal électrique de courant I peut être du type impulsionnel. En effet, les moyens PULS sont conçus pour appliquer une ou plusieurs impulsions de courant I pour récupérer et mémoriser les points caractéristiques en tension de la batterie et une ou plusieurs mesures de température. Chaque impulsion de courant peut être caractérisée avec une certaine durée et une certaine amplitude. Chaque impulsion de courant peut également être caractérisée avec un profil d'amplitude variable comme par exemple en dents de scie ou du type sinusoïdal. La réponse en tension est enregistrée et les paramètres des points caractéristiques en sont extraits. Dans ce mode de réalisation, on peut utiliser par exemple une méthode, qui consiste à appliquer une impulsion de courant constant ou de tension de durée courte cf. en haut sur la figure 2, par exemple quelques secondes, cf. « n » secondes au centre sur la figure 2 à la batterie et à mesurer la réponse en tension de la batterie $\Delta V$, cf. en bas sur la figure 2. Les mesures de tension U sont effectuées préférablement durant une période de temps avant, pendant et après l'application de l'impulsion ou des impulsions. Alternativement, les moyens PULS sont conçus pour appliquer une ou plusieurs impulsions de tension U pour récupérer et mémoriser les points caractéristiques en courant I de la batterie. Alternativement, les moyens PULS sont conçus pour appliquer une ou plusieurs impulsions de tension U et de courant I pour récupérer et mémoriser les points caractéristiques en courant I et tension U de la batterie.

Dans un mode de réalisation de l'invention, le dispositif peut comprendre une interface de communication, non représentée sur les figures, avec un utilisateur ou avec tout autre dispositif en local ou à distance. Cette interface est configurée pour afficher notamment le SOHE. Cette information pourra également être utilisée de manière automatisée pour déclencher d'autres actions dans le cadre d'un traitement automatisé du processus de tri ou de réutilisation des batteries.

Dans un mode de réalisation de l'invention, le module d'analyse CALC peut être configuré pour détecter des données atypiques ayant un profil différent des profils type de cellules contenus dans la base de données PROF. En effet, le module d'analyse CALC est configuré pour reconnaitre le profil d'une batterie BATX à diagnostiquer et si les paramètres en provenance des moyens de mesure SIG sont trop distants mathématiquement (voir explication du terme « distance Mahalanobis » plus bas) des profils contenus dans la base de données PROF, alors on parle d'un profil atypique. En effet, après un traitement mathématique de la mesure rapide des points caractéristiques en tension provenant des moyens de mesure SIG, un système de détection de données atypiques peut déterminer si cette batterie BATX peut être précisément diagnostiquées par le modèle ou non. Une donnée atypique ou « outlier » est une valeur ou une observation qui est distante mathématiquement des autres observations effectuées sur le même phénomène, c'est-à-dire qu'elle diverge des autres valeurs mesurées (cf. points en haut à gauche, entourés d'un cercle sur la figure 6 dans un repère quelconque X, Y).

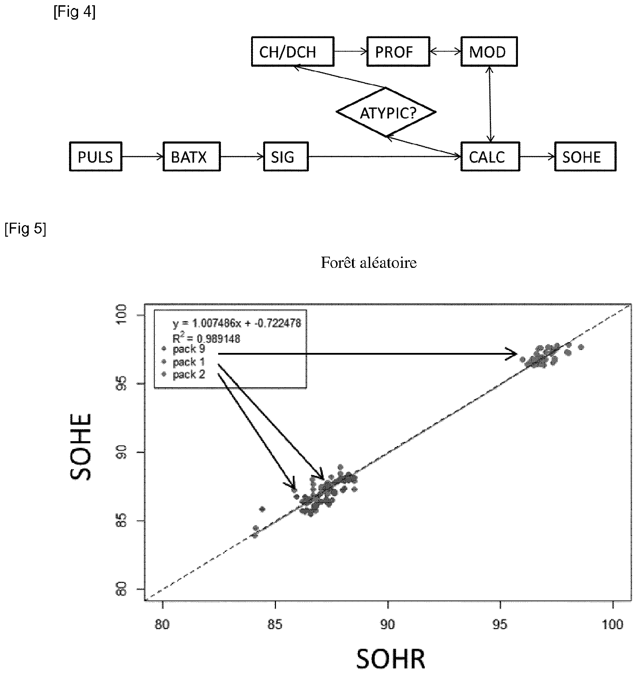

Selon un mode de réalisation de l'invention, le dispositif et le procédé de diagnostic peut comprendre également des moyens CH/DCH pour effectuer un test de charge et décharge d'une cellule pour déterminer un indicateur réel SOHR de l'état de santé de ladite au moins une cellule de la batterie, cf. figure 4. En effet, lorsqu'un profil atypique est détecté, par exemple lorsqu'on veut réaliser le diagnostic de batteries BATX d'une nouvelle référence pour laquelle on ne dispose pas de profil dans la base de données PROF, il est nécessaire d'obtenir le profil SOHR. Le profil SOHR peut s'obtenir en utilisant le test de capacité en décharge. Cette méthode temporelle est la plus classique. Il s'agit de procéder avec un cycle de charge/décharge d'une cellule à un courant assez faible (C/2 par exemple) pour mesurer la charge transférée à travers la batterie :

[Math.6]

$$\Delta Q = \int_{t=0}^{t} I_{bat} \, dt$$

Où:

$\Delta Q$ est la charge transférée à travers la batterie en Ah,
t le temps en h et
Ibat le courant de charge/décharge en A.

Une fois la charge mesurée, la formule du $SOH_E$ est appliquée.

Le test de capacité en décharge est la seule mesure de base qui fournit directement le $SOH_E$.

Le résultat du test de capacité en décharge reste généralement très fiable, cependant, cette méthode est chronophage (plusieurs heures) à cause de la nécessité d'utiliser des faibles courants de charge/décharge pour chacune des cellules d'un même module de batterie. De plus, cette méthode est consommatrice d'électricité.

En pratique, un nombre prédéfini de points de tensions U0,U1, ...,Un peuvent être mesurés à des temps caractéristiques. Alternativement, un nombre prédéfini de points de courant I0, I1, ..., In peuvent être mesurés à des temps caractéristiques. Alternativement, un nombre prédéfini de points de tensions U0,U1,... ,Un et un nombre prédéfini de points de courant I0, I1, ..., In peuvent être mesurés à des temps caractéristiques.

Ces points de tensions et/ou de courants sont utilisés comme paramètres des signaux SIG mesurés et reflètent le SOH d'une batterie. Ensuite, une mesure classique et fiable de charge/décharge de chaque batterie est également faite afin de déterminer son SOHR. Par exemple le point U0 correspond à la valeur de tension à vide OCV (acronyme anglais pour « Open Circuit Voltage »). Ce point fournit une information sur le SOC et permet à l'algorithme de prédire le SOH sans mise à SOC de la batterie à tester en amont.

Les mesures de tensions caractéristiques en réponse à une impulsion de courant dépendent de la température. Conformément à une mise en œuvre de l'invention, les mesures peuvent être toutes faites en isotherme, mais cette condition ne peut pas être remplie dans un processus industriel (temps de mise en température trop long). Une solution consiste à ajouter la variable température à l'algorithme.

Nous présentons, à titre d'exemple, un protocole de test de caractérisation électrique de batteries qui a été réalisé dans des enceintes climatiques à 25°C selon la procédure suivante :

- Décharge à C/2 : 2 cycles de charge (CC-CV) / décharge à C/2
- Décharge à C/20 : Charge/décharge à C/20 sans « floating »
- Charge (CC-CV) à C/2
- Impulsions à 3 SOCs différents (100 %, 50 %, 25 %) :

  - Impulsion en décharge de 10 s à 5 A
  - Phase de relaxation 30 min
  - Impulsion en charge de 10 s à 1 C
  - Phase de relaxation 30 min
  - Décharge C/2 pour mise à SOC
  - Phase de relaxation 30 min (puis retour point a. pour les autres SOCs).

Dans le cadre de ces tests, l'exploitation de l'ensemble des données a été faite à l'aide de scripts réalisés en langage R.

Selon un mode de réalisation de l'invention, le module d'analyse CALC peut être configuré pour transmettre tout nouveau profil type dans la base de données PROF. En effet, avant de pouvoir passer à la phase de prédiction de l'état de santé des batteries pour en établir le diagnostic, il est utile de créer un modèle de prédiction MOD et que ce dernier soit entraîné avec une base de données PROF. Pour cela, un certain nombre de batteries peuvent être caractérisées et leur profil enrichit la base de données PROF.

Selon un mode de réalisation de l'invention, la détermination du modèle de prédiction MOD et le module d'analyse CALC peuvent utiliser un algorithme à apprentissage automatique. En effet, ce mode de réalisation propose un procédé d'estimation de SOHE via l'apprentissage automatique. L'apprentissage automatique (en anglais « Machine Learning ») comporte généralement deux phases. La première consiste à estimer un modèle à partir de données (ici les données de la base de données PROF), appelées observations, qui sont disponibles et en nombre fini, lors de la phase de conception du système. Dans notre cas les observations sont les mesures fournies par les moyens SIG pour les cellules de la base de données PROF. Cette phase dite « d'apprentissage » ou « d'entraînement » est généralement réalisée préalablement à l'utilisation pratique du modèle. La seconde phase correspond à la mise en production : le modèle MOD étant déterminé, de nouvelles données peuvent alors être soumises afin d'obtenir le résultat correspondant à la tâche souhaitée. Il s'agit ici de l'étape mise en œuvre par le module d'analyse CALC. En pratique, certains systèmes peuvent poursuivre leur apprentissage une fois en production, pour peu qu'ils aient un moyen d'obtenir un retour sur la qualité des résultats produits (on parle alors d'apprentissage automatique auto-apprenant). Dans la phase d'apprentissage, la valeur de la température peut être injectée avec les points caractéristiques et le SOH à l'algorithme. Lors du diagnostic, la température peut être mesurée.

Comme on l'a vu, le modèle MOD de Machine Learning peut être vierge au départ. L'apprentissage automatique peut alors permettre d'alimenter la base de données PROF progressivement. Le modèle de prédiction sera donc fonctionnel dès les premières cellules testées. En effet, la base de données PROF contient des profils de cellules.

Lorsque l'étape d'apprentissage du modèle MOD est terminée, le modèle MOD est capable de prédire le SOHE de nouvelles batteries qui n'ont pas servi pour l'apprentissage. Nous proposons plus loin un test de fiabilité de ce modèle MOD: une nouvelle batterie BATX est donc soumise à un courant électrique. Les points caractéristiques de tension provenant des moyens SIG sont communiqués au module d'analyse CALC qui est connecté au modèle MOD, qui comporte à ce stade un algorithme de Machine Learning entrainé, « Random Forest » par exemple (pouvant être traduit par forêt aléatoire), et le SOHE est ensuite estimé. Alternativement, l'apprentissage automatique peut être de tout type, notamment une méthode de réseau de neurones, une méthode de machine à vecteurs de support (de l'anglais « Support Vecteur Machine » ou SVM), une méthode de processus gaussiens.

Les valeurs estimées par le dispositif et le procédé selon l'invention SOHE et réelles SOHR de la capacité des cellules et leur relation de régression linéaire sont illustrées sur la figure 5. Les valeurs SOHR ont été obtenues en utilisant la méthode charge-décharge complète pour évaluer la performance de modèle. Les abscisses des points de données de la figure sont les valeurs SOHR de capacité (cibles), et les ordonnées correspondantes sont les valeurs estimées SOHE de capacité (sorties du modèle selon l'invention). Idéalement, les estimations SOHE en sortie du modèle et les valeurs SOHR réelles sont égales les unes aux autres, tous les points estimés se situant donc sur la droite dont la pente est égale à 1. Le coefficient de détermination $R^2$ d'apprentissage est théoriquement de 1, qui est représenté par la ligne en pointillé de la figure. Le coefficient de détermination calculé à partir des points de données est de 0,989 (droite solide). Plus les estimations du modèle sont précises, plus la dispersion des données est proche de la ligne de régression en trait plein. Dans ce cas, la droite de régression d'apprentissage et la droite d'ajustement idéal coïncident presque, ce qui suggère que la sortie du modèle est cohérente avec les valeurs réelles et que le modèle « Random Forest » est valide. Lors des tests effectués, l'erreur de prédiction de la méthode est en moyenne de moins de 1 %. Effectivement, les résidus suivent une distribution gaussienne avec une moyenne de -0,03 %. 94 % des cellules sont estimées avec une erreur de moins de 1%. On en déduit que cette méthode selon l'invention est particulièrement précise.

Selon un mode de réalisation de l'invention (tel qu'illustré en figure 4), le module d'analyse CALC peut mettre en œuvre un processus auto-apprenant. Ce mode de réalisation propose un procédé d'estimation de SOH via l'apprentissage progressif. L'auto-apprentissage est l'aptitude d'un système à modifier son fonctionnement ou ses paramètres afin de toujours rester dans une plage de fonctionnement optimal en vue d'augmenter ses performances. Comme on l'a vu dans le mode de réalisation de l'invention mettant en œuvre un apprentissage automatique, le modèle de Machine Learning est vierge au départ. L'apprentissage automatique permet d'alimenter la base de données progressivement. Le modèle de prédiction MOD est donc fonctionnel dès les premières batteries testées. Cette méthode est utilisable sur des batteries de tout type (cellule, module ou pack) et applicable en particulier pour les centres de SAV. Comme on a vu plus haut, dans le cas où la batterie ne peut pas être diagnostiquée par le module d'analyse CALC, la méthode classique CH/DCH est utilisée pour déterminer le SOHR et fournir l'information à la base de données PROF. En effet, la mesure du SOHR et la mesure des points caractéristiques de tension servent en parallèle à améliorer l'algorithme. Par conséquent, le modèle sera de plus en plus performant dans le temps avec une précision croissante. La particularité de ce mode de réalisation à modèle auto-apprenant est de pouvoir enrichir la base de données PROF et par voie de conséquence affiner le modèle MOD au fur et à mesure, avec de nouveaux profils de cellules. En effet, on a vu dans un mode de réalisation de l'invention que le dispositif et le procédé peut être en mesure de reconnaitre des valeurs atypiques de mesures en provenance du module SIG. Dans le cadre d'un dispositif et le procédé suivant ce mode de réalisation, avec un processus auto-apprenant, lorsqu'un nouveau type de batterie est détecté grâce à l'identification d'un profil atypique, une étape de caractérisation du nouveau type de cellule est mise en place grâce aux moyens de test CH/DCH.

Le diagnostic d'une batterie BATX s'effectue donc en appliquant un signal grâce aux moyens PULS et en mesurer les paramètres grâce aux moyens SIG. Il s'en suit la détermination d'un niveau de similarité entre les tensions mesurées pour cette cellule, et la base de données PROF. Dans le cas d'une similarité importante, l'estimation du SOHE consiste en l'utilisation du modèle d'apprentissage MOD. Dans le cas d'une différence notable, on considère être en présence d'une batterie atypique et dans ce cas, la cellule est testée via une sollicitation électrique consistant en un cycle de charge/décharge complet grâce aux moyens CH/DCH, permettant de déterminer la valeur exacte du SOHR, et d'alimenter de surcroit la base de données PROF.

Selon un mode de réalisation de l'invention, le module d'analyse CALC peut être configuré pour analyser directement une batterie comprenant une pluralité de cellules connectées en série, en parallèle ou une combinaison de groupes de cellules connectées en série et en parallèle. Selon ce mode de réalisation le SOHE est déterminé pour l'ensemble du pack ou du module, indifféremment de sa constitution en sous-ensembles (modules, groups, blocs, cellules). Or un assemblage est généralement constitué d'un ensemble de blocs en série et / ou parallèle : des modules (eux-mêmes constitués d'un assemblage de cellules en série et/ou en parallèle), ou des blocs de cellules connectées en en série et/ou en parallèle. Dans ce cas, la sollicitation électrique est automatiquement appliquée à l'ensemble des sous-ensembles de la batterie. Si la tension de chacun de ces sous-ensembles est mesurée lors de l'application d'un signal électrique, il est possible de récupérer en une seule étape et sans démontage, les points caractéristiques de tension de chacun des sous-blocs et donc d'en effectuer le diagnostic.

Selon ce mode de réalisation, la phase d'apprentissage doit se faire préférablement sur les sous-ensembles à diagnostiquer, et donc les cellules ou modules démontés. Il est cependant possible de réaliser la phase d'apprentissage avec les moyens CH/DCH par des mesures en une étape à l'échelle des packs complets en mesurant la tension de chacun des sous blocs pendant la décharge. Cependant, le sous-bloc le plus faible limite la mesure pour les autres sous-blocs. Une solution peut consister à définir un SOHE pour un critère d'arrêt en tension relevé et donc une tension de fin de décharge différente de la tension minimale du sous-bloc, ou d'interpoler les courbes de décharges incomplètes pour obtenir les capacités individuelles. Le diagnostic d'un assemblage prend alors, autant de temps que le diagnostic d'un sous-bloc.

Dans ce mode de réalisation, la connaissance en particulier d'un algorithme du modèle MOD à l'échelle des cellules peut permettre de créer un algorithme du modèle MOD à l'échelle de n'importe quel assemblage eux-mêmes constitutifs d'un pack. Grâce à un traitement de données en amont de l'algorithme de Machine Learning, les données issues de cellules, de modules ou de packs peuvent être regroupées dans une seule base qui alimente le modèle. De ce fait, il n'est plus nécessaire d'avoir plusieurs modèles distincts de niveau d'assemblage différents. Grâce à une étape de normalisation des variables, il est possible, par exemple, d'utiliser des données de cellules pour prédire l'état de santé de modules. Les données issues de tests sur cellules et modules ont été regroupées dans la même base de données. Ces modes de réalisation permettent une adaptation multi-échelles du dispositif et du procédé selon l'invention.

Selon les résultats obtenus de tests effectués pour prouver la fiabilité de ce mode de réalisation, on distingue les SOHE prédits au niveau de la cellule ainsi que les SOHE prédits à l'échelle de modules constitués de 4 cellules connectées en parallèle. Le coefficient de détermination $R^2$ du modèle vaut 0,984, ce qui démontre la fiabilité de l'estimation du diagnostic dans ce mode de réalisation.

Selon un mode de réalisation de l'invention, le module d'analyse CALC et/ou la base de données PROF peuvent être configurés pour être déportés à distance, préférablement dans un nuage informatique (en anglais « cloud computing »). Selon ce mode de réalisation, tout ou partie de la partie logique et de la base de données peuvent être déportés sur un ou des serveurs informatiques distants via internet pour stocker et exploiter des données. La base de données utilisée pour la prédiction du SOH dans ce mode de réalisation est désormais déportée dans le nuage informatique et agrège les données de différents batteries testées par différents dispositifs répartis dans différents centres, par exemple des centres de SAV en France ou ailleurs. A chaque fois qu'une batterie est testée, les paramètres sont transmis sur internet dans le nuage informatique. Ce mode de réalisation pourrait être appliqué dans des logiciels de SAAS (acronyme anglais pour « Software As A Service » pouvant être traduit par logiciel en tant que service). Le SAAS est un modèle de distribution de logiciel où les applications du fournisseur sont hébergés sur des serveurs distants et les clients y ont accès à via internet. Concernant la mise en pratique de ce mode de réalisation, les opérateurs peuvent disposer de dispositifs de diagnostic dans leurs locaux. Par exemple, on peut positionner localement les moyens PULS, SIG et CH/DCH et déporter dans le nuage informatique toute ou partie de des moyens de calcul CALC, MOD et de base de données PROF. Ce mode de réalisation peut permettre par exemple de lier les centres de SAV effectuant des diagnostics de batteries en France, dans une région déterminée ou tout simplement sans limite régionale et de créer une base de données centrale PROF. On peut également envisager d'intégrer dans ce dispositif de diagnostic des paramètres spécifiques aux constructeurs de batteries ou de sous-ensembles, aux normes industrielles ou environnementales qui peuvent avoir des variantes régionales ou modulables dans le temps.

Optimisation de l'échantillonnage de la phase d'apprentissage de Machine Learning :

Lors de la phase de parangonnage, la séparation de la base de données en ensemble d'apprentissage et ensemble de validation se fait de manière aléatoire. Cette partie présente une méthode de tri des données d'alimentation de la base de données. Cette méthode est appliquée sur la technique de Machine Learning retenue, à savoir « Random Forest ».

Les méthodes de répartition aléatoire permettent d'obtenir des bons résultats. Cependant, la prévision du modèle peut être biaisée dans le cas de jeux de données d'entrées différentes de celles contenues dans les données du modèle d'apprentissage. La fiabilité du modèle d'apprentissage est donc limitée. C'est pourquoi, lors des tests effectués pour déterminer le meilleur mode de fonctionnement, d'autres méthodes de sélection des données basées sur des relations mathématiques entre les variables indépendantes (points caractéristiques de tension) mesurées ont été proposées. Elles permettent de sélectionner un ensemble d'apprentissage optimal augmentant la capacité du modèle à extrapoler sur des données d'entrée variées et augmentent, *in fine,* la robustesse du modèle de prédiction.

Selon un mode de réalisation, l'algorithme Kennard-Stone (KS) peut être appliqué pour générer un ensemble d'apprentissage avant d'injecter les données dans l'algorithme de Machine Learning. Dans cette technique, toutes les données d'entrée sont considérées comme des candidats à l'ensemble d'apprentissage. La méthode Kennard-Stone se base la distance Mahalanobis. La distance Mahalanobis (MD) est la distance entre deux points dans un espace multivarié. Dans un espace euclidien de n dimensions, les variables (par exemple x, y, z) sont représentées par des axes perpendiculaires entre eux ; la distance entre deux points p et q peut être calculée avec la formule suivante :

[Math.7]

$$d(q,p) = \sqrt{(p_1 - q_1)^2 + (p_2 - q_2)^2 + \cdots + (p_n - q_n)^2}$$

Pour les variables non corrélées, la distance euclidienne est égale à la MD. Cependant, si les dimensions (colonnes de votre base de données) sont corrélées les unes aux autres, ce qui est généralement le cas dans les bases de données expérimentales, la distance euclidienne entre un point et le centre des points (distribution) peut donner peu ou pas d'information sur la proximité réelle de ce point par rapport à la distribution des autres points. Le MD résout ce problème de mesure, car il mesure les distances entre les points, même les points corrélés et cela pour plusieurs variables. La distance Mahalanobis se calcule de la façon suivante :

[Math.8]

$$D^2 = (x - m)^T \cdot C^{-1} \cdot (x - m)$$

Où :

$D^2$ est le carré de la distance Mahalanobis,
$x$ est le vecteur de la donnée d'entrée (ligne dans une base de données),
$m$ est le vecteur des valeurs moyennes des variables indépendantes (moyenne de chaque colonne) et
$C^{-1}$ est la matrice de covariance inverse des variables indépendantes.

Les étapes impliquées dans la sélection de l'ensemble d'apprentissage basé sur l'algorithme KS basé sur la distance Mahalanobis (MD) sont les suivantes:

Etape 1 : Les deux premiers jeux de paramètres de l'ensemble d'apprentissage sont sélectionnées en choisissant les deux jeux de paramètres qui sont les plus éloignés les uns des autres en terme de distance Mahalanobis.
Etape 2 : Trouver le jeu de paramètres qui a une différence maximale de chacun des jeux de paramètres précédemment sélectionnés et l'intégrer dans l'ensemble d'apprentissage.
Etape 3 : Répétez l'étape 2 jusqu'à ce que le nombre souhaité de données ait été ajouté à l'ensemble d'apprentissage.

Les autres données ont été placées dans l'ensemble de validation.

70 % des données de la base sont ainsi sélectionnées grâce à la méthode Kennard-Stone ensuite injectées dans Random Forest pour entraîner le modèle. Les 30 % restantes sont utilisées pour vérifier sa performance. La sélection optimale de l'ensemble de données en sous-ensemble d'apprentissage et sous-ensemble validation indépendant est une étape importante et critique afin d'améliorer la précision des modèles de prédiction.

**Revendications**

1. Dispositif de diagnostic d'une batterie BATX, notamment de type Li-ion, non embarquée provenant d'un véhicule électrique, à assistance électrique, véhicule électrique hybride rechargeable ou tout autre dispositif utilisant une batterie, la batterie BATX étant composée d'une cellule ou d'une pluralité de cellules, ledit dispositif comprenant :

   • des moyens PULS configurés pour appliquer à au moins une cellule de ladite batterie un signal électrique de courant I et/ou de tension U
   • des moyens de mesure SIG de la tension U et/ou de courant I et de la température T de ladite au moins une cellule de la batterie
   • un module d'analyse CALC, un modèle de prédiction MOD construit à partir d'une base de données PROF contenant des profils type de cellules, **caractérisé en ce que** :
   • le module d'analyse CALC est configuré pour déterminer un indicateur de l'état de santé énergie SOHE d'au moins une cellule de ladite batterie BATX en utilisant les mesures de tension U et/ou de courant I et de température T provenant des moyens de mesure SIG ainsi que le modèle de prédiction MOD.

2. Dispositif selon la revendication 1, le signal électrique de courant I et/ou de tension U est du type impulsionnel.

3. Dispositif selon l'une des revendications précédentes comprenant une interface de communication avec un utilisateur, ladite interface est configurée pour afficher l'indicateur de l'état de santé énergie SOHE.

4. Dispositif selon l'une des revendications précédentes, dans lequel le module d'analyse CALC est configuré pour détecter des données atypiques ayant un profil différent des profils type de cellules contenus dans la base de données PROF.

5. Dispositif selon l'une des revendications précédentes, qui comprend des moyens CH/DCH pour effectuer un test de charge et décharge d'une cellule pour déterminer un indicateur réel de l'état de santé d'au moins une cellule de de ladite batterie SOHR.

6. Dispositif selon l'une des revendications précédentes, dans lequel le module d'analyse CALC est configuré pour transmettre un nouveau profil type dans la base de données PROF.

7. Dispositif selon l'une des revendications précédentes, dans lequel le module d'analyse CALC est du type apprentissage automatique.

8. Dispositif selon l'une des revendications précédentes, dans lequel le module d'analyse CALC met en œuvre un processus auto-apprenant.

9. Dispositif selon l'une des revendications précédentes, dans lequel le module d'analyse CALC est configuré pour analyser directement une batterie comprenant une pluralité de cellules connectées en série, en parallèle ou une combinaison de groupes de cellules connectés en série et en parallèle.

10. Dispositif selon l'une des revendications précédentes, dans lequel le module d'analyse CALC et/ou la base de données PROF et/ou MOD sont configurés pour être déportés à distance, préférablement dans un nuage informatique.

11. Procédé de diagnostic d'une batterie BATX, notamment de type Li-ion, non embarquée provenant d'un véhicule électrique, à assistance électrique, véhicule électrique hybride rechargeable ou tout autre dispositif utilisant une batterie, la batterie BATX étant composée d'une cellule ou d'une pluralité de cellules, ledit procédé comprenant :

   • une étape d'application à ladite au moins une cellule de la batterie un signal électrique de courant I et/ou de tension U
   • une étape de mesure de la tension U et/ou de courant I et de la température T de ladite au moins une cellule de la batterie
   • une étape délivrant le diagnostic d'au moins une cellule de ladite batterie, utilisant un module d'analyse CALC des mesures de tension U et de température T,

   **caractérisé en ce que** le procédé comprend également:

• une étape de comparaison des mesures de tension U et/ou de courant I et de température T avec des profils type de cellules contenus dans une base de données afin de déterminer un indicateur de l'état de santé SOHE de ladite au moins une cellule de la batterie.

12. Procédé de diagnostic selon la revendication 11 mettant en œuvre le dispositif de l'une des revendications 2 à 10.

**Patentansprüche**

1. Vorrichtung zur Diagnose einer BATX-Batterie, insbesondere vom Li-Ionen-Typ, nicht eingebaut, aus einem Elektrofahrzeug, einem Fahrzeug mit elektrischer Unterstützung, einem wiederaufladbaren Hybridelektrofahrzeug oder einer beliebigen anderen Vorrichtung, die eine Batterie verwendet, wobei die BATX-Batterie aus einer Zelle oder einer Vielzahl von Zellen besteht, wobei die Vorrichtung Folgendes beinhaltet:

   • PULS-Mittel, die dazu konfiguriert sind, an mindestens eine Zelle der Batterie ein elektrisches Strom(I)- und/oder Spannungs(U)-Signal anzulegen,
   • SIG-Mittel zum Messen der Spannung U und/oder des Stroms I und der Temperatur T der mindestens einen Zelle der Batterie,
   • ein CALC-Analysemodul, ein MOD-Vorhersagemodell, das auf Grundlage einer PROF-Datenbank, die typische Zellenprofile enthält, erstellt wurde, **dadurch gekennzeichnet, dass**:
   • das CALC-Analysemodul dazu konfiguriert ist, einen Indikator für den Energiegesundheitszustand, SOHE, mindestens einer Zelle der BATX-Batterie unter Verwendung der Spannungs(U)- und/oder Strom(I)- und Temperatur(T)-Messungen aus den SIG-Messmitteln sowie des MOD-Vorhersagemodells zu bestimmen.

2. Vorrichtung nach Anspruch 1, wobei das elektrische Strom(I)- und/oder Spannungs(U)-Signal vom Typ Impulssignal ist.

3. Vorrichtung nach einem der vorhergehenden Ansprüche, die eine Kommunikationsschnittstelle zu einem Benutzer beinhaltet, wobei die Schnittstelle dazu konfiguriert ist, den Indikator für den Energiegesundheitszustand, SOHE, anzuzeigen.

4. Vorrichtung nach einem der vorhergehenden Ansprüche, wobei das CALC-Analysemodul dazu konfiguriert ist, atypische Daten zu detektieren, die ein Profil aufweisen, das sich von den typischen Zellenprofilen, die in der PROF-Datenbank enthalten sind, unterscheidet.

5. Vorrichtung nach einem der vorhergehenden Ansprüche, die CH/DCH-Mittel beinhaltet, um einen Lade- und Entladetest einer Zelle durchzuführen, um einen tatsächlichen Indikator des Gesundheitszustands mindestens einer Zelle der Batterie, SOHR, zu bestimmen.

6. Vorrichtung nach einem der vorhergehenden Ansprüche, wobei das CALC-Analysemodul dazu konfiguriert ist, ein neues typisches Profil in die PROF-Datenbank zu übertragen.

7. Vorrichtung nach einem der vorhergehenden Ansprüche, wobei das CALC-Analysemodul vom Typ maschinelles Lernen ist.

8. Vorrichtung nach einem der vorhergehenden Ansprüche, wobei das CALC-Analysemodul einen selbstlernenden Prozess umsetzt.

9. Vorrichtung nach einem der vorhergehenden Ansprüche, wobei das CALC-Analysemodul dazu konfiguriert ist, eine Batterie, die eine Vielzahl von Zellen, die in Reihe oder parallel verbunden sind, oder eine Kombination von Zellengruppen, die in Reihe und parallel verbunden sind, beinhaltet, direkt zu analysieren.

10. Vorrichtung nach einem der vorhergehenden Ansprüche, wobei das CALC-Analysemodul und/oder die PROF-Datenbank und/oder das MOD dazu konfiguriert sind, sich entfernt, vorzugsweise in einer Cloud, zu befinden.

11. Verfahren zur Diagnose einer BATX-Batterie, insbesondere vom Li-Ionen-Typ, nicht eingebaut, aus einem Elektrofahrzeug, einem Fahrzeug mit elektrischer Unterstützung, einem wiederaufladbaren Hybridelektrofahrzeug oder einer beliebigen anderen Vorrichtung, die eine Batterie verwendet, wobei die BATX-Batterie aus einer Zelle oder einer Vielzahl von Zellen besteht, wobei das Verfahren Folgendes beinhaltet:

> • einen Schritt des Anlegens, an die mindestens eine Zelle der Batterie, eines elektrischen Strom(I)- und/oder Spannungs(U)-Signals,
> • einen Schritt des Messens der Spannung U und/oder des Stroms I und der Temperatur T der mindestens einen Zelle der Batterie,
> • einen Schritt, der die Diagnose für mindestens eine Zelle der Batterie stellt, unter Verwendung eines CALC-Analysemoduls für die Spannungs(U)- und Temperatur(T)-Messungen,

**dadurch gekennzeichnet, dass** das Verfahren ferner Folgendes beinhaltet:

> • einen Schritt des Vergleichens der Spannungs(U)- und/oder Strom(I)- und Temperatur(T)-Messungen mit typischen Zellenprofilen, die in einer Datenbank enthalten sind, um einen Indikator für den Gesundheitszustand, SOHE, der mindestens einen Zelle der Batterie zu bestimmen.

12. Diagnoseverfahren nach Anspruch 11, das die Vorrichtung nach einem der Ansprüche 2 bis 10 einsetzt.

## Claims

1. Device for diagnosing an off-board battery BATX, in particular of Li-ion type, from an electric vehicle, electric assistance vehicle, rechargeable hybrid electric vehicle or any other device using a battery, the battery BATX being composed of one cell or of a plurality of cells, said device comprising:

> • means PULS configured to apply to at least one cell of said battery an electrical signal of current I and/or of voltage U
> • means SIG for measuring the voltage U and/or current I and the temperature T of said at least one cell of the battery
> • an analysis module CALC, a prediction model MOD constructed from a database PROF containing typical cell profiles, **characterized in that**:
> • the analysis module CALC is configured to determine an indicator of the energy state of health SOHE of at least one cell of said battery BATX by using the measurements of voltage U and/or of current I and of temperature T from the measuring means SIG along with the prediction model MOD.

2. Device according to Claim 1, the electrical signal of current I and/or of voltage U being of the pulse type.

3. Device according to either of the preceding claims, comprising an interface for communicating with a user, said interface being configured to display the indicator of the energy state of health SOHE.

4. Device according to one of the preceding claims, wherein the analysis module CALC is configured to detect atypical data having a profile different from the typical cell profiles contained in the database PROF.

5. Device according to one of the preceding claims, which comprises means CH/DCH for carrying out a charge and discharge test of a cell to determine a real indicator of the state of health of at least one cell of said battery SOHR.

6. Device according to one of the preceding claims, wherein the analysis module CALC is configured to transmit a new typical profile into the database PROF.

7. Device according to one of the preceding claims, wherein the analysis module CALC is of the machine learning type.

8. Device according to one of the preceding claims, wherein the analysis module CALC implements a self-learning process.

9. Device according to one of the preceding claims, wherein the analysis module CALC is configured to directly analyse a battery comprising a plurality of cells connected in series, in parallel or a combination of groups of cells connected in series and in parallel.

10. Device according to one of the preceding claims, wherein the analysis module CALC and/or the database PROF and/or MOD are configured to be located remotely, preferably in a computer cloud.

11. Method for diagnosing an off-board battery BATX, in particular of Li-ion type, from an electric vehicle, electric assistance vehicle, rechargeable hybrid electric vehicle or any other device using a battery, the battery BATX being composed of one cell or of a plurality of cells, said method comprising:

   • a step of applying to said at least one cell of the battery an electrical signal of current I and/or of voltage U
   • a step of measuring the voltage U and/or current I and the temperature T of said at least one cell of the battery
   • a step delivering the diagnosis of at least one cell of said battery, using an analysis module CALC to analyse the measurements of voltage U and of temperature T,

   **characterized in that** the method also comprises:

   • a step of comparing the measurements of voltage U and/or of current I and of temperature T with typical cell profiles contained in a database in order to determine an indicator of the state of health SOHE of said at least one cell of the battery.

12. Diagnosis method according to Claim 11 implementing the device of one of Claims 2 to 10.

[Fig 1]

[Fig 2]

[Fig 3]

[Fig 4]

[Fig 5]

Forêt aléatoire

y = 1.007486x + -0.722478
$R^2$ = 0.989148
• pack 9
• pack 1
• pack 2

SOHE

SOHR

[Fig 6]

[Fig 7]

## RÉFÉRENCES CITÉES DANS LA DESCRIPTION

**Documents brevets cités dans la description**

- US 20110060538 A1
- US 10302703 B2
- FR 3044424
- US 2016245876 A
- US 2019113577 A
- CN 109932663 A
- CN 109061508 A
- CN 103091642 A

**Littérature non-brevet citée dans la description**

- **COLEMAN M.** ; **HURLEY W.G.** ; **LEE C.K.** An Improved Battery Characterization Method Using a Two-Pulse Load Test. *IEEE Transactions on Energy Conversion*, 2008, vol. 23 (2), 708-713